(19) Europäisches Patentamt
European Patent Office
Office européen des brevets

(11) Veröffentlichungsnummer: **0 425 891 A2**

(12) **EUROPÄISCHE PATENTANMELDUNG**

(21) Anmeldenummer: **90119878.8**

(22) Anmeldetag: **17.10.90**

(51) Int. Cl.⁵: **C08L 61/06**, C08K 5/59, G03F 7/038

(30) Priorität: **27.10.89 DE 3935876**

(43) Veröffentlichungstag der Anmeldung: **08.05.91 Patentblatt 91/19**

(84) Benannte Vertragsstaaten: **BE CH DE FR GB IT LI NL SE**

(71) Anmelder: **BASF Aktiengesellschaft
Carl-Bosch-Strasse 38
W-6700 Ludwigshafen(DE)**

(72) Erfinder: **Nguyen Kim, Son, Dr.
Zedernweg 9
W-6944 Hemsbach(DE)**

(54) **Strahlungsempfindliches Gemisch.**

(57) Die Erfindung betrifft ein strahlungsempfindliches Gemisch, aus

a) einem in Wasser unlöslichen, in wäßrig-alkalischen Lösungen löslichen Bindemittel oder Bindemittelgemisch auf Basis parasubstituierter Phenol/Formaldehyd-Harze, die an ihren Kettenenden in ortho-Stellung teilweise Methylolgruppen oder Gruppierungen, die bei Einwirkung von Säure Methylolgruppen ergeben, und in para-Stellung -OR-Gruppen, worin R für Alkyl, Aralkyl oder Acyl steht, enthalten und

b) einer bei Bestrahlung eine starke Säure bildenden Verbindung

Das strahlungsempfindliche Gemisch eignet sich zur Herstellung lichtempfindlicher Beschichtungsmaterialien und Reliefstrukturen.

EP 0 425 891 A2

## STRAHLUNGSEMPFINDLICHES GEMISCH

Die Erfindung betrifft strahlungsempfindliche Gemische, die negativ arbeitend sind, ein in Wasser unlösliches, in wäßrig-alkalischen Lösungen lösliches Bindemittel, eine unter Einwirkung von Strahlung eine Säure bildende Verbindung und Gruppierungen, die durch säurekatalytische Einwirkung mit dem Bindemittel bei erhöhter Temperatur zur Vernetzung führen, enthalten. Diese Gemische sind sensitiv gegenüber UV-, Elektronen- und Röntgenstrahlen und eignen sich besonders als Resistmaterial.

Negativ arbeitende strahlungsempfindliche Gemische sowie Verfahren zur Bildherstellung mittels dieser Gemische sind bekannt. Unter negativ arbeitenden Photoresists werden dabei solche verstanden, bei denen nach der bildmäßigen Belichtung der lichtempfindlichen Schicht die belichteten Bereiche dieser Schicht, gegebenenfalls nach einer zusätzlichen Wärmebehandlung, in der Entwicklerlösung, in der sie vor der Belichtung löslich waren, unlöslich sind.

Im allgemeinen basieren negativ arbeitende Photoresists auf photopolymerisierbaren Gemischen, die neben einem polymeren Bindemittel eine photopolymerisierbare Verbindung und einen Photoinitiator enthalten. Die am meisten verwendeten negativ arbeitenden Photoresists für die Herstellung integrierter Schaltungen enthalten fast ausnahmslos partiell cyclisiertes Polyisopren als vernetzbare Komponente und eine Diazid-Verbindung als lichtempfindlichen difunktionellen Vernetzer. Als Diazide sind hierbei solche der Struktur (A)

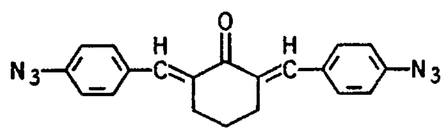

(A)

sehr gebräuchlich.

Neuerdings sind auch negativ arbeitende Photoresists, die aus teilcyclisiertem Polybutadien und Diaziden bestehen, im Handel erhältlich (vgl. auch Harita, Y., Ichigawa, M., Harada, K., Polym. Eng. Sci., 17 (1977), 372).

Eine Reihe negativ arbeitender Photoresists beasiert auch auf der Photodimerisierung als Vernetzungsreaktion. Hierher gehören die Zimtsäurederivate und die ihnen im Aufbau verwandten Chalkone. Die Vernetzungsreaktion verläuft im wesentlichen als lichtinduzierte [2+2]-Cycloaddition unter Bildung von Cyclobutanen (vgl. Williams, J.L.R.: Fortschr. Chem. Forsch., 13 (1969), 227; Reiser, A., Egerton, P.L.: Photogr. Sci. Eng., 23 (1979), 144; M. Kato et al: J. Polym. Sci. part B, Polym. Lett. Ed. 8 (1970), 263; M. Kato et al: Photogr. Sci. Eng., 23 (1979), 207).

In den letzten Jahren hat auch noch ein schon längere Zeit bekannter Typ photodimerisierbarer Epoxidharze als Photoresist Verwendung gefunden (vgl. z.B. DE-A-14 47 016; DE-A-23 42 407; DE-A-25 53 346 sowie DE-A-24 49 926). Diese Harze tragen sowohl Gruppierungen, die Photocycloadditionen ermöglichen, z.B. Chalkonreste, als auch Epoxygruppen, die thermisch katalysiert nachvernetzt werden können (vgl. Photoresist, New York,: McGraw Hill (1975); GB-PS 892 111 und US-A 2 852 379).

Außer den negativ arbeitenden Photoresisten, die ein Diazid der oben genannten Struktur (A) enthalten, sind die Photoreaktionen nur im NUV-Bereich (d.h. bei 350 bis 450 nm) möglich. Neue Diazidverbindungen für den kurzwelligen UV-Bereich wurden in den letzten Jahren beschrieben. Dazu gehören Ketonverbindungen (vgl. J. Elektrochem. Soc. (1981) 6) sowie schwefelhaltige Diazidverbindungen (vgl. J. Elektrochem. Soc., 127 (1980), 2759).

Auch negativ arbeitende wäßrig-alkalisch entwickelbare Photoresists, die im kurzwelligen UV strukturierbar sind, sind bekannt. Hierzu werden Poly(p-vinylphenol) als Bindemittel und 3,3'-Diazidodiphenylsulfon verwendet (vgl. IEEE Trans. Electron Devices, ED. 28 (1981), 1306; IEEE Trans. Electron Devices, ED-28 (1981), 1284). Ein weiterer wäßrig-alkalisch entwickelbarer negativ arbeitender Photoresist basiert auf einem Oniumsalz und Methylacrylamidoglycolatmethylether (vgl. Hult et al; Polymers for high Tech. ACS Symposium Series 346 (1987), 162 bis 169), der auf dem Prinzip der säurekatalytischen Selbst-Kondensation zur Vernetzung des Bindemittels beruht.

Eine weitere photopolymerisierbare Zusammensetzung, die auf einem säurehärtbaren Material und einem Jodoniumsalz als Säurespender basiert, ist aus der DE-A-2 602 574 bekannt.

Auch säurekatalytische Vernetzer, zu denen beispielsweise die als Zwischenprodukte bei der Kondensation von Phenol/Formaldehyd-Harz erhältlichen Arylmethylolverbindungen gehören, waren bereits bekannt (vgl. Progr. Org. Coat. 9 (1981), 107; DE-A-29 04 961; Plastics and Rubber Processing and Application 1

(1981), 39; DE-A-32 47 754; EP-A-01 39 309; JP 3051424-A). Auch für photostrukturierbares Aufzeichnungsmaterial hat dieser säurekatalytische Vernetzer Anwendung gefunden. In EP-A-0282724 wird über ein neues negativ arbeitendes System, das auf Poly(p-hydroxystyrol), einem Säurespender und einem Vernetzer mit mindestens zwei geschützten Methylolgruppen basiert, berichtet; anstelle Poly(p-hydroxystyrol) kann auch m-Kresol-Formaldehyd-Harz eingesetzt werden. Analog wurde in PCT/US 87/02743 ein anderes Negativ-System beschrieben, in dem auch Poly(p-hydroxystyrol) oder m-Kresol-Formaldehyd-Novolake als Bindemittel, ein 1,2-Chinondiazid als Säurespender und ein 2,6-Dimethylol-p-Kresol als Vernetzer eingesetzt wird. Nachteile der beiden obengenannten Systeme sind: hohe Herstellungskosten aller Bindemittel auf Basis von Poly(p-hydroxystyrol) sowie die hohe optische Dichte (≙ niedrige Transmittance) im kurzwelligen Bereich ($\lambda \leqq 300$ nm) von m-Kresol-Formaldehyd-Harz; daher werden Novolake auf Basis von m-Kresol und Formaldehyd vorzugsweise für Resiste, die im mittleren UV-Bereich (MID-UV: $\lambda$ = 300-380 nm) transparent sind, eingesetzt. Auch eine andere thermisch vernetzende Verbindung, die ein Harnstoff- bzw. Urethan-Formaldehydkondensatprodukt ist, wurde neuerdings in DE-A-3 711 264 als Vernetzer für lichtempfindliche Gemische beschrieben. Aufgabe der vorliegenden Erfindung war es, neue kostengünstige hochaktive strahlungsempfindliche Systeme auf Novolak-Basis für die Herstellung von im kurzwelligen UV lichtempfindlichen Schichten aufzuzeigen, die sich mit wäßrig-alkalischen Lösungen entwickeln lassen.

Gegenstand der vorliegenden Erfindung ist ein strahlungsempfindliches Gemisch, im wesentlichen bestehend aus

a) einem in Wasser unlöslichen, in wäßrig-alkalischen Lösungen löslichen Bindemittel oder Bindemittelgemisch auf Basis parasubstituierter Phenol/Formaldehyd-Harze, die an ihren Kettenenden in ortho-Stellung teilweise Methylolgruppen oder Gruppierungen, die bei Einwirkung von Säure Methylolgruppen ergeben, und in para-Stellung Gruppen der allgemeinen Formel (I) .

-OR (I)

worin R für Alkyl, beispielsweise mit 1 bis 8 Kohlenstoffatomen, z.B. Methyl oder Ethyl;
Aralkyl, beispielsweise Benzyl oder Acyl, beispielsweise mit 1 bis 4 Kohlenstoffatomen, z.B.

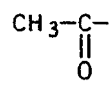

steht, enthalten,

und

b) einer bei Bestrahlung eine starke Säure bildendenden Verbindung,

das dadurch gekennzeichnet ist, daß Komponente (a) ein Polymer der allgemeinen Formel (II) ist,

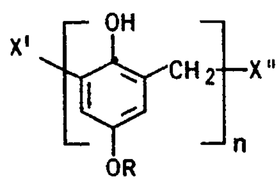

(II)

worin

X′ für H, $CH_2OH$ oder $CH_2OR'$

X″ für OH, OR′ oder

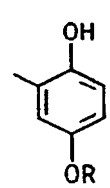

,

R′ für eine säurelabile Gruppe steht,

die Gruppen -OR teilweise, bis zu 95 % dieser Gruppen, durch Alkylgruppen ersetzt sein können, und

n für eine positive ganze Zahl ≧ 2, vorzugsweise 5 bis 30 steht.

Für den Fall, daß in der allgemeinen Formel (II) X′ für $CH_2OR'$ oder X″ für OR′ steht, wird als säurelabile Gruppe R′ einer der Reste

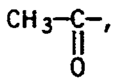, 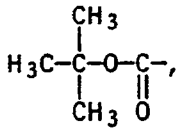, 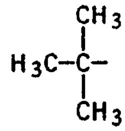 oder 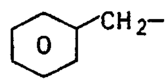

bevorzugt.

Eine bevorzugte Ausführungsform besteht auch darin, daß das Bindemittel (a) aus einem Gemisch aus einem Polymer der Formel (II) und einem oder mehreren phenolischen Harzen, die an den Phenolkernen eine oder mehrere freie o-Stellungen aufweisen, wobei es sich bei den phenolischen Harzen mit einer oder mehreren freien o-Stellungen am Phenolkern um p-Kresol/Formaldehyd-Harze oder um Poly-(p-hydroxystyrol) handeln kann.

Das Bindemittel (a) der allgemeinen Formel (II) weist im allgemeinen ein mittleres Molekulargewicht $\overline{M}_w$ zwischen 150 und 20.000, vorzugsweise zwischen 200 und 5.000 auf.

Die erfindungsgemäßen strahlungsempfindlichen Gemische enthalten das Bindemittel (a) im allgemeinen in einer Menge von 50 bis 99 Gew.-%, bezogen auf die Gesamtmenge des strahlungsempfindlichen Gemisches.

Als bei der Bestrahlung eine starke Säure bildende Verbindung (b) können die erfindungsgemäßen strahlungsempfindlichen Gemische Sulfoniumsalze der Formel

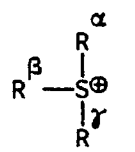 $A^{\ominus}$

worin $R^{\alpha}$, $R^{\beta}$ und $R^{\gamma}$ untereinander gleich oder verschieden sind und für Alkyl mit 1 bis 3 Kohlenstoffatomen, wie z.B. Methyl oder Ethyl, Aryl, wie z.B Phenyl, substituiertes Aryl, wie z.B. substituiertes Phenyl, oder Aralkyl, wie z.B. Benzyl, stehen, und $A^{\ominus}$ = $ClO_4^{\ominus}$, $AsF^{6\ominus}$, $SbF^{6\ominus}$, $PF^{6\ominus}$, $BF^{4\ominus}$ und/oder $CF_3SO_3^{\ominus}$ ist, insbesondere Sulfoniumsalze der allgemeinen Formel (IV), oder auch Jodoniumsalze der allgemeinen Formel (V) oder Polychlorverbindungen der allgemeinen Formel (VI) enthalten,

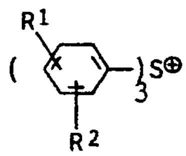 $A^{\ominus}$, 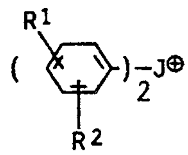 $A^{\ominus}$ oder $R^3-CCl_3$

(IV) (V) (VI)

worin

$R^1$ und $R^2$ untereinander gleich oder verschieden sind und für H, OH oder einen der Reste

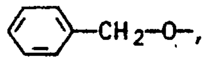, $(C_1-$ bis $C_4-Alkyl)_3\ Si-O-$,

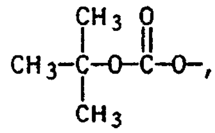, 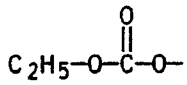 oder 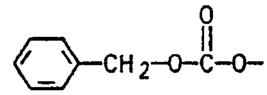

stehen,

$R^3$ = 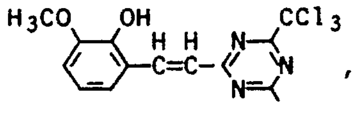, 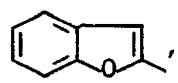, 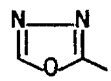 oder 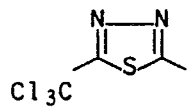

und

$A^{\ominus}$ = $Cl^{\ominus}$, $Br^{\ominus}$, $ClO_4^{\ominus}$, $AsF_6^{\ominus}$, $PF_6^{\ominus}$, $SbF_6^{\ominus}$, $CF_3SO_3^{\ominus}$ und/oder $BF_4^{\ominus}$ ist.

Besonders bevorzugte Sulfoniumsalze sind z.B.

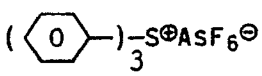 oder

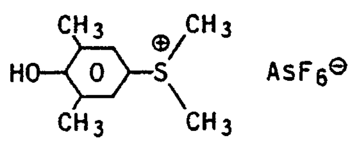

Ein bevorzugtes Jodoniumsalz ist z.B.

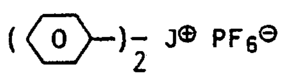

Die erfindungsgemäßen strahlungsempfindlichen Gemische enthalten die Komponente (b) im allgemeinen in einer Menge von 1 bis 50 Gew.-%, bezogen auf die Gesamtmenge des strahlungsempfindlichen Gemisches und können zusätzlich einen Sensibilisator enthalten, der Strahlung absorbiert und auf Komponente (b) überträgt.

Gegenstand der vorliegenden Erfindung sind außerdem ein Verfahren zur Herstellung lichtempfindlicher Beschichtungsmaterialien, wobei das erfindungsgemäße strahlungsempfindliche Gemisch eingesetzt wird, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120 °C, bildmäßiges Belichten, Erhitzen auf Temperaturen von 60 bis 160 °C und Entwickeln mit einer wäßrig-alkalischen Lösung, wobei das erfindungsgemäße strahlungsempfindliche Gemisch eingesetzt wird.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether, Ester und aromatische Kohlenwasserstoffe, sowie Mischungen derselben in Frage. Besonders bevorzugt sind Alkylenglykolmonoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methylpropylenglykol-acetat, und Ethylpropylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers bzw. Novolaks und der photoempfindlichen Komponente.

Weiterhin können andere Zusätze wie Haftvermittler, Netzmittel, Farbstoffe und Weichmacher zugesetzt

werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch Farbstoffe, die als Sensibilisatoren wirken, verwendet werden.

Bei dem erfindungsgemäßen Verfahren zur Herstellung von Reliefmustern bzw. Reliefstrukturen wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, dap die Löslichkeit der belichteten Bereiche nach einem thermischen Ausheizschritt bei Temperaturen zwischen 60 und 160°C in wäßrig-alkalischen Lösungsmitteln abnimmt und die unbelichteten Bereiche selektiv mit dem alkalischen Entwickler entfernt werden können.

Das erfindungsgemäße strahlungsempfindliche Gemisch eignet sich als Photoresist zur Herstellung von Reliefstrukturen für Halbleiterbauelemente.

Die das erfindungsgemäße strahlungsempfindliche Gemisch enthaltenden Photoresistlösungen können durch ein Filter mit einem Porendurchmesser von etwa 0,2 µm filtriert werden und werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) z.B. bei 1000 bis 10.000 U/Minute, aufgetragen, getrocknet (z.B. 1 bis 5 Minuten bei Temperaturen zwischen 70 und 130, vorzugsweise 80 bis 90°C) und mit einer geeigneten Lichtquelle durch eine Photomaske z.B. eine chrombeschichtete strukturierte Quarzmaske) bildmäßig belichtet. Als Lichtquellen eignen sich insbesondere kurzwellige UV-Strahlen (deep UV) mit Wellenlängen zwischen 200 und 300 nm sowie auch Elektronen- oder Röntgenstrahlen. Besonders geeignete Lichtquellen sind Quecksilberlampen, Excimer-Laser von KrF ($\lambda$ = 248 nm). Nach dem bildmäßigen Belichten wird - gegebenenfalls nach kurzem Ausheizen (2 Sekunden bis 5 Minuten) (postbake) bei Temperaturen zwischen 60 und 160°C - mit üblichen wäßrig-alkalischen Entwicklerlösungen - im allgemeinen bei pH-Werten zwischen 12 und 14 - oder alkoholischen Entwicklern entwickelt, wobei sich die unbelichteten Bereiche selektiv ablösen, während in den belichteten Bereichen nur wenig Abtrag stattfindet. Die Auflösung liegt im Submikron-Bereich. Die für die erfindungsgemäßen strahlungsempfindlichen Gemische benötigte Belichtungsenergie liegt im allgemeinen zwischen 15 und 200 mJ/cm$^2$ bei Schichtdicken von 1 µm.

Die in den Beispielen angegebenen Teile und Prozente sind, soweit nicht anders angegeben, Gewichtsteile bzw. Gewichtsprozente.

Beispiel 1

a) Herstellung des p-substituierten Novolakharzes

16,8 g 2,6-Di(hydroxymethyl)-4-methylphenol und 11,2 g 4-Methoxy-phenol werden in 50 g Methylglykol aufgeschlämmt und mit 6 g o-Phosphorsäure (85%ig) versetzt.

Unter $N_2$-Spülung läßt man 30 Minuten bei 70°C rühren, wobei bei ca. 50°C eine klare Lösung entsteht. Anschließend läßt man 5 Stunden am Rückfluß kochen. Nach Beendigung der Reaktionszeit werden 60 ml Methylglykol zugegeben, so daß eine verdünnte klare Lösung entsteht. Diese wird unter starkem Rühren in 1,5 l destilliertes Wasser gegossen, wobei man weißgelbe, feinverteilte Flocken erhält. Diese werden abgesaugt, mit $NaHCO_3$-Lösung und dest. Wasser neutral gewaschen und im Vakuum-Trockenschrank zuerst bei Raumtemperatur, dann bei 70°C getrocknet. Ausbeute 25,6 g. Dieses Polykondensat wird nachstehend kurz mit N-Nov. 1 bezeichnet.

b) Herstellung der Resistlösung

Eine Photoresistlösung wurde aus 95 Teile N-Nov., 1,5 Teilen Triphenylsulfoniumhexafluoroarsenat (der Fa. Alfa) und 280 Teilen Cyclohexanon hergestellt und durch ein Filter mit einem Porendurchmesser von 0,2 µm filtriert.

Die Resistlösung wurde in üblicher Weise auf einen oxidierten Siliciumwafer in einer Schichtdicke von 1 µm aufgeschleuert. Der Wafer wurde eine Minute auf einer Heizplatte bei 100°C getrocknet und anschließend mit einer Testmaske im Kontaktverfahren mit Excimer-Laser der Wellenlänge $\lambda$ = 248 nm belichtet. Die Belichtungsenergie betrug 40 mJ/cm$^2$. Danach wurde eine Minute bei 120°C ausgeheizt und mit einem

Entwickler von pH-Wert 12,0 bis 14,0 entwickelt.

Vergleichsbeispiel zu Beispiel 1

a) Herstellung des p-substituierten Novolak ohne Alkoxygruppe (= N-Nov. 2)

Gemäß Beispiel 1a) wurde der Novolak N-Nov. 2 aus 2,6-Di(hydroxymethyl)-4-methylphenol und 4 Benzylphenol hergestellt.

b) Herstellung und Testen der Resistlösung aus N-Nov. 2

Eine Photoresistlösung wurde aus 95 Teilen N-Nov. 2, 5 Teilen Triphenylsulfoniumhexafluoroarsenat und 280 Teilen Cyclohexanon hergestellt.

Es wurde dann weiter wie im Beispiel 1b) verfahren. Der Lack ließ sich weder positiv noch negativ strukturieren.

Beispiel 2

Eine Photoresistlösung wurde aus 90 Teilen N-Nov. 1, 10 Teilen Diphenyljodoniumhexafluorophosphat (der Fa. Alfa) und 280 Teilen Cyclohexanon hergestellt.

Es wurde wie im Beispiel 1 verfahren. Die Empfindlichkeit für 1 µm Resistschichtdicke betrug ca. 80 $mJ/cm^2$.

Beispiel 3

Eine Photoresistlösung wurde aus 60 Teilen N-Nov. 1, 32 Teilen Poly(p-hydroxystyrol) (= kommerzielles Produkt der Fa. Polysciences Inc., $\overline{M}_w$ = 1500 bis 7000 g/mol), 8 Teilen Triphenylsulfoniumhexafluoroarsenat und 280 Teilen Diglyme (= $HO-(CH_2)_2-O-(CH_2)_2-OH$) hergestellt.

Es wurde wie in Beispiel 1 verfahren. Die Empfindlichkeit für 1 µm Resistschichtdicke betrug ca. 75 $mJ/cm^2$.

**Ansprüche**

1. Strahlungsempfindliches Gemisch, im wesentlichen bestehend aus

(a) einem in Wasser unlöslichen, in wäßrig-alkalischen Lösungen löslichen Bindemittel oder Bindemittelgemisch auf Basis parasubstituierter Phenol/Formaldehyd-Harze, die an ihren Kettenenden in ortho-Stellung teilweise Methylolgruppen oder Gruppierungen, die bei Einwirkung von Säure Methylolgruppen ergeben, und in para-Stellung Gruppen der allgemeinen Formel (I)

-OR (I)

worin

R für Alkyl, Aralkyl oder Acyl steht, enthalten,

und

b) einer bei Bestrahlung eine starke Säure bildenden Verbindung,

dadurch gekennzeichnet, dap Komponente (a) ein Polymer der allgemeinen Formel (II) ist,

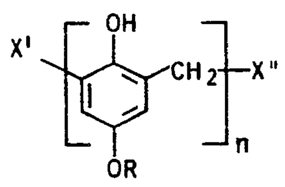

(II)

worin
X′ für H, $CH_2OH$ oder $CH_2OR'$
X″ für OH, OR′ oder

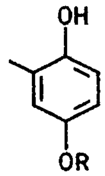,

R′ für eine säurelabile Gruppe steht,
die Gruppen -OR teilweise durch Alkylgruppen ersetzt sein können, und
n für eine positive ganze Zahl ≧ 2 steht.

2. Strahlungsempfindliches Gemisch nach Anspruch 1, dadurch gekennzeichnet, dap für den Fall, daß in der allgemeinen Formel (II) X′ für $CH_2OR'$ oder X″ für OR′ steht, die säurelabile Gruppe R′ einen der Reste

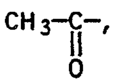, 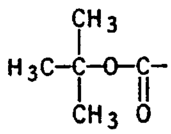, 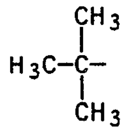 oder 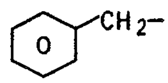

bedeutet.

3. Strahlungsempfindliches Gemisch nach einem der vorhergehenden Ansprüche, dadurch gekennzeichnet, daß das Bindemittel (a) ein Gemisch aus einem Polymer der Formel (II) und einem oder mehreren phenolischen Harzen, die an den Phenolkernen eine oder mehrere freie o-Stellungen aufweisen, ist.

4. Strahlungsempfindliches Gemisch nach Anspruch 3, dadurch gekennzeichnet, daß es sich bei den phenolischen Harzen mit einer oder mehreren freien o-Stellungen am Phenolkern um p-Kresol/Formaldehyd-Harze oder um Poly-(p-hydroxystyrol) handelt.

5. Strahlungsempfindliches Gemisch nach Anspruch 1 oder 2, dadurch gekennzeichnet, daß das Bindemittel (a) der allgemeinen Formel (II) ein mittleres Molekulargewicht $\overline{M}_w$ zwischen 150 und 20.000 aufweist.

6. Strahlungsempfindliches Gemisch nach einem der vorgehenden Ansprüche, dadurch gekennzeichnet, daß das Bindemittel (a) in einer Menge von 50 bis 99 Gew.-%, bezogen auf die Gesamtmenge des strahlungsempfindlichen Gemisches, enthalten ist.

7. Strahlungsempfindliches Gemisch nach einem der Ansprüche 1 bis 6, dadurch gekennzeichnet, daß als bei der Bestrahlung eine starke Säure bildende Verbindung (b) ein Sulfoniumsalz der Formel

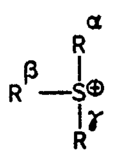 $A^{\ominus}$

eingesetzt wird, worin $R^{\alpha}$, $R^{\beta}$ und $R^{\gamma}$ untereinander gleich oder verschieden sind und für Alkyl mit 1 bis 3 Kohlenstoffatomen, Aryl, substituiertes Aryl oder Aralkyl stehen, und $A^{\ominus}$ = $ClO_4^{\ominus}$, $AsF^{6\ominus}$, $SbF^{6\ominus}$, $PF^{6\ominus}$, $BF^{4\ominus}$ und/oder $CF_3SO_3^{\ominus}$ ist.

8. Strahlungsempfindliches Gemisch nach einem der vorhergehenden Ansprüche, dadurch gekennzeichnet, daß als bei der Bestrahlung eine starke Säure bildende Verbindung (b) ein Sulfoniumsalz der allgemeinen Formel (IV), ein Jodoniumsalz der allgemeinen Formel (V) oder eine Polychlorverbindung der allgemeinen Formel (VI)

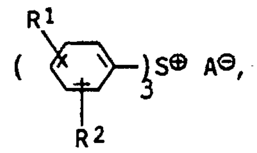
(IV)

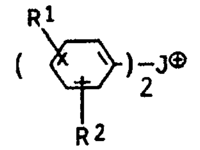
(V)

$A^{\ominus}$ oder $R^3$—$CCl_3$

(VI)

worin
$R^1$ und $R^2$ untereinander gleich oder verschieden sind und für H, OH oder einen der Reste

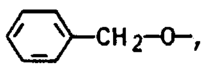, $(C_1$- bis $C_4$-Alkyl$)_3$ Si—O—,

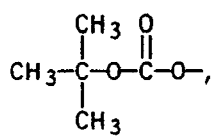, 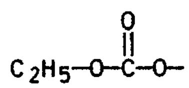 oder 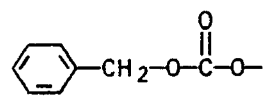

stehen,

$R^3$ = 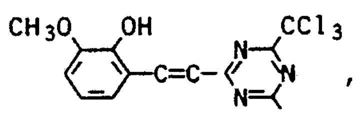, 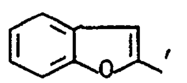, 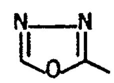 oder 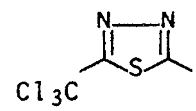

und
$A^{\ominus}$ = $Cl^{\ominus}$, $Br^{\ominus}$, $ClO_4^{\ominus}$, $AsF_6^{\ominus}$, $PF_6^{\ominus}$, $SbF_6^{\ominus}$, $CF_3SO_3^{\ominus}$ und/oder $BF_4^{\ominus}$,
eingesetzt wird.

9. Strahlungsempfindliches Gemisch nach einem der vorhergehenden Ansprüche, dadurch gekennzeichnet, daß Komponente (b) in einer Menge von 1 bis 50 Gew.%, bezogen auf die Gesamtmenge des strahlungsempfindlichen Gemisches, enthalten ist.

10. Strahlungsempfindliches Gemisch nach Anspruch 1, dadurch gekennzeichnet, dap es zusätzlich einen Sensibilisator enthält, der Strahlung absorbiert und auf Komponente (b) überträgt.

11. Verfahren zur Herstellung lichtempfindlicher Beschichtungsmaterialien, dadurch gekennzeichnet, dap ein strahlungsempfindliches Gemisch gemäß einem der vorhergehenden Ansprüche eingesetzt wird.

12. Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 120° C, bildmäßiges Belichten, Erhitzen auf Temperaturen von 60 bis 160° C und Entwickeln mit einer wäßrig-alkalischen Lösung, dadurch gekennzeichnet, daß ein strahlungsempfindliches Gemisch nach einem der Ansprüche 1 bis 10 eingesetzt wird.